# EUROPEAN PATENT SPECIFICATION

(11) **EP 4 006 564 B1**
(45) Date of publication and mention of the grant of the patent: **16.10.2024**
(21) Application number: 20858205.6
(22) Date of filing: 18.08.2020
(51) Int. Cl.: G01R 31/392, G01R 31/367, G01R 31/3835, G01R 31/36, G08B 21/18, H01M 10/48, H01M 10/42, G01R 31/388, H01M 10/44

(54) **METHOD FOR PREDICTING SOH OF BATTERY AND BATTERY PACK EMPLOYING SAME**
VERFAHREN ZUR SOH-VORHERSAGE EINER BATTERIE UND BATTERIEPACK DAMIT
PROCÉDÉ DE PRÉDICTION DE L'ÉTAT DE SANTÉ D'UNE BATTERIE ET BLOC-BATTERIE L'UTILISANT

(30) Priority: 23.08.2019 KR 20190103485; 05.08.2020 KR 20200098001
(43) Date of publication of application: 01.06.2022
(73) Proprietor: LG ENERGY SOLUTION, LTD., Seoul 07335 (KR)
(72) Inventor: LIM, Bo Mi, Daejeon 34122 (KR)
(74) Representative: Plasseraud IP
(86) International application number: PCT/KR2020/010997
(87) International publication number: WO 2021/040306

(56) References cited:
- EP-A1- 2 963 433
- EP-A1- 3 657 190
- JP-A- 2016 009 659
- JP-A- 2019 020 392
- JP-A- 2019 020 392
- JP-A- 2019 056 595
- JP-A- 2019 056 595
- JP-A- 2019 509 610
- US-A1- 2012 116 701
- US-A1- 2019 113 577

## Description

### [Technical Field]

The present invention relates to a battery SOH prediction method and a battery pack using the same, and more specifically, to a method of predicting the SOH of a battery in real time during charging/discharging and a battery pack using the same.

### [Background Art]

As rechargeable secondary batteries (hereinafter referred to as 'batteries') that are used as energy sources in various fields ranging from portable electronic devices such as smartphones, notebook computers and PDAs to electric vehicles and energy storage systems (ESS) are continuously used for a longer period of time and are charged/discharged repeatedly, there is a characteristic of shortening the lifespan, and this gradually decreases the capacity/performance of the batteries. The deterioration of the capacity/performance of the battery due to these characteristics affects the stable operation of the system using the battery.

Therefore, predicting the state of health (SOH) of the battery makes it possible to determine when the battery needs replacement, and accordingly, it is possible to minimize the negative effects that may occur due to the decrease in capacity/performance of the battery, so that this allows the system using the battery to operate stably.

On the other hand, in relation to the related art in predicting the State of Health (SOH) of the battery, by using ampere counting (Ahcounting) based on current integration while performing complete discharge of the battery cell, it was predicted by calculating the state of health (SOH) of the battery cell.

However, in order to predict the State of Health (SOH) of the battery in the conventional method, since it is necessary to completely discharge the battery forcibly, there is a problem of inefficient and cumbersome time in battery operation, and as the operation of completely discharging the battery is repeated, there is a possibility that it may cause a decrease in capacity/performance of the battery.
(Patent Literature 1) KR10-1211789 B1
JP2019 056595 relates to a secondary battery system capable of estimating a deterioration index of a secondary battery. JP2019 020392 relates to an estimation device applicable to an accumulation of electricity element having a monopole that quantity of accumulation of electricity-electric potential properties change by repetition of charging and discharging. EP2963433 relates to a battery state estimation method and apparatus that includes a time detector configured to detect a time during which a voltage level of a battery, being partially charged and discharged, changes through a constant current charge.

### [Disclosure]

### [Technical Problem]

The present invention is to solve the above-described problem, and an object of the present invention is to provide a method for predicting the SOH of a corresponding battery in real time during charging/discharging, even if the battery is not completely discharged.

### [Technical Solution]

A battery SOH prediction method according claim 1 is provided in a first aspect.

A battery management device for measuring an SOH of a battery according to claim 5 is provided in a second aspect.

Moreover, a battery pack includes the battery management device according to the above-mentioned present invention.

### [Advantageous Effects]

Because the present invention does not require complete discharge as in the related art for predicting the state of health (SOH) of the battery, it is possible to improve the efficiency of time when operating the battery and to know the State of Health (SOH) of the battery in real time during charging/discharging, so that more stable battery operation is possible.

### [Description of Drawings]

FIG. 1 is a flowchart showing a method of predicting a battery SOH according to the present invention.
FIG. 2 is an experimental graph showing dQ/dV values of the first reference battery voltage derivation operation of deriving a battery voltage in which the dQ/dV value deviation is the largest among a plurality of cycles, as a result of the comparison.

In addition, the battery SOH prediction operation includes an SOH extraction operation of extracting an SOH corresponding to actual dQ/dV measured in the actual dQ/dV value measurement operation from the dQ/dV:SOH lookup table and is an operation of predicting the extracted SOH as a real-time SOH of the actual battery.

Furthermore, the abnormality determination operation includes: a dQ/dV value deviation calculation operation of calculating a deviation |dQ/dV(t)-dQ/dV(t-1)| between a dQ/dV value of a current period and a dQ/dV value of a previous period measured in the actual dQ/dV value measurement operation; and a dQ/dV value deviation comparison operation of comparing the calculated dQ/dV value deviation between the current period and the previous period with a predetermined reference value.

Here, when the dQ/dV value deviation between the current period and the previous period exceeds the predetermined reference value, it is determined that there is an abnormality in the corresponding battery.

A battery management device for measuring an SOH of a battery according to the present invention includes: a charge/discharge control unit configured to supply charge/discharge power to the battery and control charge/discharge; an SOH measurement battery voltage setting unit configured to set an SOH measurement battery voltage based on each cycle specific dQ/dV value measured for each cycle of a plurality of completely charging-completely discharging for a predetermined reference battery; an SOH prediction unit configured to measure an actual dQ/dV value at the set SOH measurement battery voltage at predetermined periodic intervals while charging of the actual battery is in progress, and using this, predict a real-time SOH of the actual battery; and a storage unit configured to store a lookup table (dQ/dV:SOH lookup table) that is a relationship between dQ/dV values at each battery voltage and a corresponding SOH, which is configured based on dQ/dV values measured during completely discharging and an SOH value corresponding thereto, for the reference battery.

Moreover, the device further includes: an abnormality determination unit configured to determine whether a corresponding battery has an abnormality according to a change width of dQ/dV values using the actual dQ/dV values measured by the SOH prediction unit; a display unit configured to display a real-time SOH of the actual battery predicted by the SOH prediction unit; and a notification unit configured to generate an abnormality signal alarm when the abnormality determination unit determines that an abnormality occurs in the battery.

Specifically, the SOH measurement battery voltage setting unit includes: a first dQ/dV value measurement unit configured to measure cycle specific dQ/dV values of a plurality of completely charging-completely discharging while the operation cycle of completely charging-completely discharging the reference battery by the charge/discharge control unit is performed a predetermined number of times; and a reference battery voltage derivation unit configured to compare each cycle specific dQ/dV value measured by the first dQ/dV value measurement unit, and derive a battery voltage in which the dQ/dV value deviation is the largest between a plurality of cycles, wherein the SOH measurement battery voltage setting unit sets the derived battery voltage as an SOH measurement battery voltage.

Moreover, the SOH prediction unit includes: a second dQ/dV value measurement unit configured to measure an actual dQ/dV value at the set SOH measurement battery voltage at predetermined periodic intervals while charging the actual battery by the charge/discharge control unit; and an SOH extraction unit configured to extract an SOH corresponding to the actual dQ/dV value measured in the second dQ/dV value measurement unit from the dQ/dV:SOH lookup table stored in the storage unit, wherein the SOH prediction unit predicts the extracted SOH as a real-time SOH of the actual battery.

Furthermore, the abnormality determination unit includes: a dQ/dV deviation calculation unit configured to calculate a deviation |dQ/dV(t)-dQ/dV(t-1)| between a dQ/dV value of a current period and a dQ/dV value of a previous period measured for the actual battery by the second dQ/dV value measurement unit; a comparison unit configured to compare a dQ/dV value deviation between a current period and a previous period calculated by the dQ/dV deviation calculation unit with a predetermined reference value; and an abnormality signal generation unit configured to determine that there is an abnormality in the corresponding battery and generate and output an abnormality signal when the dQ/dV value deviation between the current period and the previous period exceeds a predetermined reference value upon a comparison result of the comparison unit.

Moreover, a battery pack includes the battery management device according to the above-mentioned present invention.

### [Advantageous Effects]

Because the present invention does not require complete discharge as in the related art for predicting the state of health (SOH) of the battery, it is possible to improve the efficiency of time when operating the battery and to know the State of Health (SOH) of the battery in real time during charging/discharging, so that more stable battery operation is possible.

### [Description of Drawings]

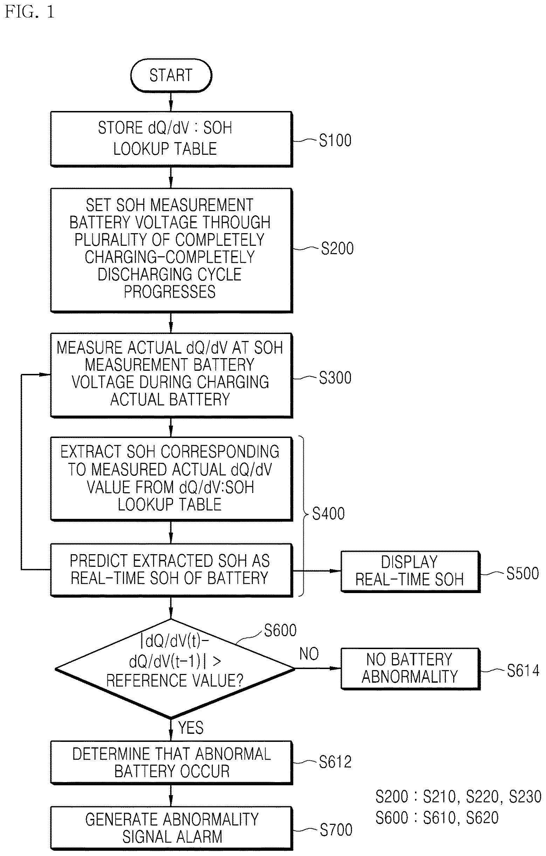

FIG. 1 is a flowchart showing a method of predicting a battery SOH according to the present invention.

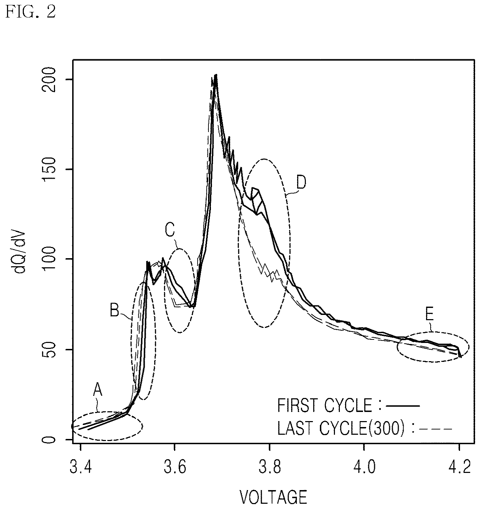

FIG. 2 is an experimental graph showing dQ/dV values of the first cycle and the 300th cycle, which appear when an operation cycle of completely charging-completely discharging is performed 300 times for a reference battery.

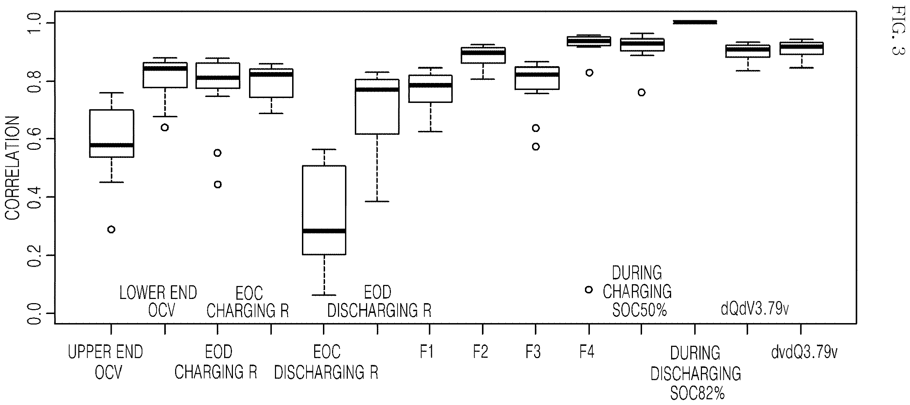

FIG. 3 is an experimental graph showing the results of analyzing the correlation between changes in OCV, R, dQ and dV values and an SOH.

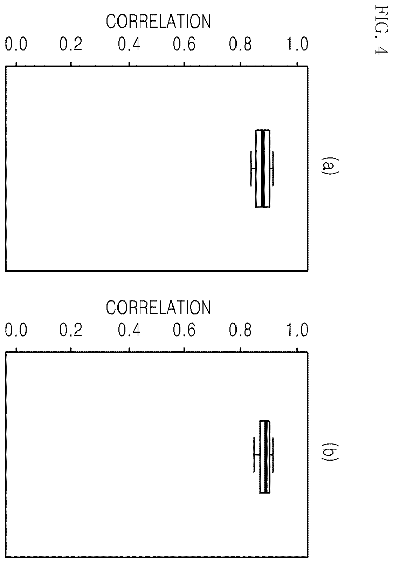

FIG. 4 is an experimental graph showing the results of analyzing the correlation between dQ, dV and an SOH at an SOH measurement battery voltage.

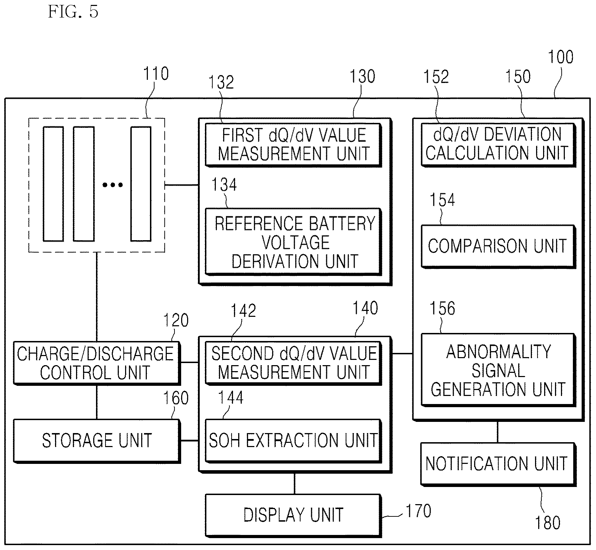

FIG. 5 is a block diagram schematically showing the overall configuration of a battery pack according to the present invention.

### [Best Mode]

Hereinafter, embodiments of the present invention will be described in detail with reference to the accompanying drawings so that those of ordinary skill in the art may easily implement the present invention. However, the present invention may be implemented in various forms and is not limited to the embodiments described herein. In the drawings, parts irrelevant to the description are omitted in order to clearly describe the present invention, and like reference numerals refer to like elements throughout the specification.

Hereinafter, the present invention will be described in detail with reference to the drawings.

### 1. Terms used in the present invention

### 1.1. Reference battery

As a battery set to prepare reference data for predicting the SOH of a specific battery, one of a plurality of batteries is set as a reference battery, and reference data is prepared by performing a full-discharge operation for the set reference battery, and based on these, a lookup table can be configured as described in operation S100 of storing the lookup table below.

### 1.2. Actual battery

As a battery to predict an SOH, based on the lookup table configured for the reference battery, an SOH can be predicted in real time by using data measured through charging progress of the actual battery.

### 1.3. dQ/dV value

This means a value obtained by differentiating the charge/discharge capacity Q of the battery measured according to the charging/discharging progress by the voltage (V).

### 2. Battery SOH prediction method according to the present invention

### 2.1. Lookup table storing operation S100

The operation of storing of the lookup table is operation of measuring real-time dQ/dV values and corresponding SOH values while completely discharging a predetermined reference battery and of configuring and storing a lookup table of dQ/dV values at each battery voltage and a corresponding SOH based on the measured dQ/dV and SOH values. The lookup table of the dQ/dV value of the battery voltage and the corresponding SOH is stored in a storage unit 160 to be described later. The lookup table is hereinafter referred to as a dQ/dV:SOH lookup table.

### 2.2. SOH measurement battery voltage setting operation S200

As an operation of measuring cycle specific dQ/dV values of a plurality of full charge-discharge for the reference battery, comparing each cycle specific dQ/dV value, and deriving the battery voltage with the largest dQ/dV value deviation to set the battery voltage as the SOH measurement battery voltage, this consists of the following detailed operations, and this is performed by an SOH measurement battery voltage setting unit 130 to be described later.

### A. Cycle specific dQ/dV value measurement operation S210

As an operation of measuring cycle specific dQ/dV values of a plurality of full-discharge for the reference battery, the operation of fully charging and discharging the reference battery is performed a predetermined number of times, and the dQ/dV values are measured during each cycle. This is performed by a first dQ/dV value measurement unit 132 to be described later.

### B. Cycle specific dQ/dV value comparison operation S220

This operation compares each cycle specific dQ/dV value measured through the cycle specific dQ/dV value measurement operation S210.

As mentioned above, since the dQ/dV value is measured during each cycle by performing a number of operation cycles for fully charging and discharging a predetermined reference battery, each cycle specific dQ/dV values are calculated, and accordingly, cycle specific dQ/dV values can be compared to check the dQ/dV values showing the greatest deviation between cycles.

### C. Reference battery voltage derivation operation S230

Based on a result of comparing each cycle specific dQ/dV value in the cycle specific dQ/dV value comparison operation S220, it is an operation for deriving the battery voltage in which the deviation of the dQ/dV value is the largest.

As specifically described with reference to the drawings, FIG. 2 is a graph showing dQ/dV values of the first cycle and the 300th cycle in which the deviation of dQ/dV values is the largest among the dQ/dV values measured for each cycle by performing a full-discharge operation cycle 300 times for the reference battery. Referring to FIG. 2, a portion showing a dQ/dV value deviation of more than a predetermined reference between the first cycle and the 300th cycle can be roughly extracted into regions A, B, C, D, and E, and among them, it can be seen that D is the portion where the deviation of dQ/dV values is the largest. Accordingly, 3.79V, which is the voltage value corresponding to the region D, is derived as the reference battery voltage, and this is hereinafter referred to as the SOH measurement battery voltage.

The cycle specific dQ/dV value comparison operation S220 and the reference battery voltage derivation operation S230 are performed by the reference battery voltage derivation unit 134 to be described later.

### 2.3. Actual dQ/dV value measurement operation S300

As an operation of measuring the measured dQ/dV value at the SOH measured battery voltage set through the reference battery voltage derivation operation S230 while charging the actual battery to measure an SOH, the actual dQ/dV value measurement operation is operated by the second dQ/dV value measurement unit 142 of an SOH prediction unit 140 to be described later. Here, the reason for measuring the actual dQ/dV value during charging of the battery is that since discharge can be performed differently depending on the user, but charging has less change than discharging, and the ionic characteristics of the battery in charging appear better than in discharging, in order to increase the accuracy of SOH prediction, the actual dQ/dV value measurement operation is performed during charging of the actual battery. Referring to FIG. 2, in describing the experiment described above as an example, since the SOH measurement battery voltage is set to 3.79V, in this operation, the dQ/dV value at 3.79V is measured while charging the actual battery.

The operation of measuring dQ/dV value at the SOH measurement battery voltage during charging of the actual battery is performed at predetermined periodic intervals, so that the SOH can be predicted in real time during charging and discharging of the actual battery.

### 2.4. Battery SOH prediction operation S400

In the battery SOH prediction operation, the SOH corresponding to the dQ/dV value at the SOH measurement battery voltage for the measured actual battery is extracted from the lookup table, so that the extracted SOH can be predicted as a real-time SOH of the actual battery.

As more specifically described, by performing the SOH extraction operation S410, the SOH corresponding to the dQ/dV value at the SOH measurement battery voltage for the actual battery measured in the measured dQ/dV value measurement operation S300 is extracted from the dQ/dV:SOH lookup table configured through the lookup table storage operation S100. At this time, the extracted SOH can be predicted as the real-time SOH of the actual battery.

When the experiment described above with reference to FIG. 2 is described as an example, an SOH corresponding to the dQ/dV value of the actual battery at 3.79V (SOH measurement battery voltage) measured in the measured dQ/dV value measurement operation S300 is extracted from the dQ/dV: SOH lookup table, so that the extracted SOH is predicted as the real-time SOH of the actual battery.

This operation is performed by the SOH extraction unit 144 of the SOH prediction unit 140 to be described later.

### 2.5. SOH display operation S500

The SOH display operation is an operation for displaying the real-time SOH of the actual battery predicted in the battery SOH prediction operation S400, and through this, the user can recognize the real-time SOH of the actual battery. This is performed by a display unit 170 to be described later.

### 2.6. Abnormality determination operation S600

The abnormality determination operation is an operation that determines whether the actual battery is abnormal according to the change width of dQ/dV values based on the dQ/dV value of the actual battery measured at predetermined periodic intervals by the actual dQ/dV value measurement operation S300, and is performed by an abnormality determination unit 150 to be described later.

### A. dQ/dV value deviation calculation operation S610

The difference between the dQ/dV value of the current period and the dQ/dV value of the previous period |dQ/dV(t)- dQ/dV(t-1)| can be calculated using the dQ/dV value at the SOH measurement battery voltage of the actual battery measured by the actual dQ/dV value measurement operation S300. This is performed by the dQ/dV deviation calculation unit 152 described later.

### B. dQ/dV value deviation comparison operation S620

By comparing the calculated dQ/dV value deviation between the current period and the previous period with a predetermined reference value, it is possible to determine whether an actual battery is abnormal according to the comparison result.

As a result of the comparison, if the dQ/dV value deviation between the current period and the previous period is greater than a predetermined reference value, it may be seen that the dQ/dV value is larger than the reference due to an abnormality in the battery, and it may be determined (S612) that an abnormality occurs.

Meanwhile, if the dQ/dV value deviation between the current period and the previous period is less than or equal to a predetermined reference value, it may be seen that the change width of the dQ/dV value is at an appropriate level, and it may be determined (S614) that there is no abnormality.

Such an operation is performed by the comparison unit 154 described later.

### 2.7. Abnormality notification operation S700

As an operation of generating an abnormality signal alarm so that a user can detect an abnormality in the battery when it is determined that an abnormality occurs in the actual battery in the abnormality determination operation S600, the abnormality notification operation includes generating an abnormality signal alarm in the notification unit 180 according to the generation of an abnormality signal from the abnormality signal generation unit 156. In such a way, in describing the principle of using the change in dQ and dV values to predict the SOH of the battery in the present invention, first, when the operation cycle of completely charging-completely discharging the cell was performed 300 times, and the correlation analysis between each element and SOH was performed, referring to FIG. 3, on the basis of the bold lines, the rest last voltage value (upper end OCV) is 0.59 after charging, It was analyzed to have a correlation that the rest last voltage value (lower end OCV) after discharging is 0.81, an End of Discharge (EOD) charging resistance is 0.77, an End of Charge (EOC) charging resistance is 0.79, an End of Discharge (EOD) discharging resistance is 0.28, an End of Charge (EOC) discharging resistance is 0.69, and dQ and dV changes were analyzed to have correlations of 0.93 and 0.94, respectively. Therefore, it can be check that the change in dQ and dV values has a higher correlation with SOH than the OCV and resistance R values.

More specifically, if the correlation between the dQ and dV value change and the SOH is analyzed, as described above with reference to FIG. 2, when the completely charging-completely discharging operation cycle is performed 300 times for the reference battery and the measured dQ/dV value for each cycle is shown in a graph, the voltage, that is, 3.79V, corresponding to the dQ/dV value of the first cycle and the 300th cycle in which the deviation in dQ/dV values between cycles is the largest can be set as the SOH measurement battery voltage. Based on this, by analyzing the correlation between dQ/dV, dV/dQ and SOH corresponding to 3.79V, which is the SOH measurement battery voltage, the result as shown in FIG. 4 could be checked. While performing an operation cycle of completely charging-completely discharging for a plurality of cells 300 times, FIG. 4 is a graph showing the average SOH correlation value for the 3.79V (SOH measurement battery voltage) portion during charging and the average SOH correlation value for 3.79V (SOH measurement battery voltage) during discharging, and as shown in (a), the average value of the SOH correlation for the dQ/dV portion of 3.79V during charging is 0.88, and as shown in (b), the average value of the SOH correlation for the dV/dQ portion of 3.79V at discharging is also 0.88, so that it can be checked that the dQ and dV values in the SOH measurement battery voltage during charging/discharging and the SOH have a high correlation.

Accordingly, the present invention uses a point having a high correlation with the dQ/dV value and the SOH at a specific voltage portion (SOH measurement battery voltage) derived through an experiment during battery charging/discharging, based on this, even if the battery is not completely discharged, since it is possible to predict the SOH of the battery in real time during charging/discharging, it is possible to improve the efficiency of time in operating the battery, and since the State of Health (SOH) of the battery can be known in real time during charging/discharging, more stable battery operation is possible.

### 3. Battery pack according to the present invention

FIG. 5 is a block diagram schematically showing the overall configuration of a battery pack according to the present invention, and each configuration will be described with reference to this.

### 3.1. Battery 110

A battery pack 100 according to the present invention includes a plurality of batteries, and the plurality of batteries can be described by dividing into a reference battery allowing one SOH measurement and at least one actual battery to measure SOH.

Furthermore, the battery pack according to the present invention includes a battery management device for measuring the SOH of the battery, which is configured as follows.

### 3.2. Charge/discharge control unit 120

As a component for supplying charging/discharging power to the battery and controlling charging/discharging, it may control to perform an operation cycle of completely charging-completely discharging the battery set as the reference battery a predetermined number of times, and may control the charging/discharging operation of the battery set as the actual battery.

### 3.3. SOH measurement battery voltage setting unit 130

It is a component to measure the cycle specific dQ/dV value of completely charging-completely discharging for a predetermined reference battery, and derive the battery voltage at which the deviation of dQ/dV values between each cycle is the largest, and sets the value as the SOH measurement battery voltage, which is the reference battery voltage for predicting the SOH of the battery.

### A. First dQ/dV value measurement unit 132

The first dQ/dV value measurement unit may measure dQ/dV values during each cycle while the operation cycle of completely charging-completely discharging a predetermined reference battery by the charge/discharge control unit 120 is performed a predetermined number of times.

For example, if an operation cycle of completely charging-completely discharging a predetermined reference battery is performed 300 times, dQ/dV is measured for each cycle from the first cycle to the 300th cycle.

A number of completely charging-completely discharging cycle specific dQ/dV values for the measured reference battery are stored in a storage unit 160 to be described later by configuring a lookup table of the dQ/dV values and the SOH, and are used to derive the reference battery voltage for SOH prediction.

### B. Reference battery voltage derivation unit 134

Based on a plurality of completely charging-completely discharging cycle specific dQ/dV values for the reference battery measured by the first dQ/dV value measurement unit 132, a reference battery voltage for predicting the SOH of the battery can be derived.

Specifically, by comparing the dQ/dV values for each cycle measured by the first dQ/dV value measurement unit 132, the battery voltage in which the dQ/dV value deviation between cycles is the largest may be derived.

As described above, FIG. 2 is a graph showing dQ/dV values of a first cycle and a 300th cycle showing the greatest deviation among dQ/dV values measured for each cycle by performing 300 cycles of completely charging-completely discharging for the reference battery. In describing the experimental data as an example with reference to FIG. 2, there are roughly areas A, B, C, D, and E that show some dQ/dV deviation between the first cycle and the 300th cycle, and among them, the battery voltage of 3.79V, which corresponds to the area D showing the greatest deviation, is derived and this can be set as the SOH measurement battery voltage as a reference battery voltage for predicting the SOH of the battery.

### 3.4. SOH prediction unit 140

The SOH prediction unit can predict the real-time SOH of the actual battery by using the SOH measurement battery voltage value set by the SOH measurement battery voltage setting unit 130, the dQ/dV: SOH lookup table stored in the storage unit 160 to be described later, and the dQ/dV value of the actual battery to measure an SOH.

### A. Second dQ/dV value measurement unit 142

The second dQ/dV value measurement unit may measure an actual dQ/dV value of the SOH measurement battery voltage at predetermined periodic intervals with respect to the actual battery while the actual battery is charged by the charge/discharge control unit 120.

Taking the experiment described above with reference to FIG. 2 as an example, since the SOH measurement battery voltage was set to 3.79V, the second dQ/dV value measurement unit measures the dQ/dV value at 3.79V of the actual battery at predetermined periodic intervals while the actual battery is charged.

### B. SOH extraction unit 144

When the dQ/dV value in the SOH measurement battery voltage of the actual battery is measured in the second dQ/dV value measurement unit 142, the SOH extraction unit may extract SOH corresponding to the measured dQ/dV value from the dQ/dV:SOH lookup table stored in the storage unit 160.

At this time, the extracted SOH can be predicted as real-time SOH of the actual battery.

Taking the experiment described above with reference to FIG. 2 as an example, an SOH corresponding to the dQ/dV value at 3.79V (SOH measurement battery voltage) of the actual battery measured by the second dQ/dV value measurement unit 142 is extracted from the dQ/dV: SOH lookup table stored in the storage unit, and at this time, the extracted SOH is predicted as the real-time SOH of the actual battery.

### 3.5. Abnormality determination unit 150

The abnormality determination unit can determine whether the actual battery is abnormal according to the change width of dQ/dV values based on the dQ/dV value of the actual battery measured at predetermined periodic intervals in the second dQ/dV value measurement unit 142.

### A. dQ/dV deviation calculation unit 152

First, the dQ/dV deviation calculation unit may calculate the deviation|dQ/dV(t)- dQ/dV(t-1)| between the dQ/dV value of the current period and the dQ/dV value of the previous period using the dQ/dV value in the SOH measurement battery voltage of the actual battery measured by the second dQ/dV value measurement unit 142.

### B. Comparison unit 154

When the dQ/dV value deviation|dQ/dV(t)- dQ/dV(t-1)| is calculated between the current period and the previous period by the dQ/dV deviation calculation unit 152, the comparison unit may compare this with a predetermined reference value.

As the result of the comparison, if the dQ/dV value deviation between the current period and the previous period is greater than a predetermined reference value, it may be seen that the dQ/dV value is larger than the reference due to an abnormality in the actual battery, and it may be determined that an abnormality occurs.

Meanwhile, if the dQ/dV value deviation between the current period and the previous period is less than or equal to a predetermined reference value, it may be seen that the change width of the dQ/dV value is at an appropriate level, and it may be determined that there is no abnormality.

### C. Abnormality signal generation unit 156

As a result of the comparison of the comparison unit 154, if it is determined that the dQ/dV value deviation between the current period and the previous period is greater than a predetermined reference value, and it is determined that an abnormality occurs in the corresponding actual battery, the abnormality signal generation unit may generate an abnormality signal and output the generated abnormality signal to a notification unit 180 to be described later.

### 3.6. Storage unit 160

The storage unit stores a dQ/dV:SOH lookup table that allows real-time SOH prediction of the actual battery using the dQ/dV value of the SOH measurement battery voltage measured for the actual battery in the SOH prediction unit 140.

While completely discharging a predetermined reference battery, the dQ/dV:SOH lookup table may constitute a lookup table of dQ/dV values at each battery voltage and a corresponding SOH through an experiment that measures dQ/dV values and corresponding SOH in real time and store these data in the storage unit. In this way, the dQ/dV:SOH lookup table stored in the storage unit is used to predict the real-time SOH of the actual battery in the SOH prediction unit 140 described above.

### 3.7. Display unit 170

The display unit is configured to display the real-time SOH of the actual battery predicted by the SOH prediction unit 140, so that this allows the user to recognize the real-time SOH of the actual battery.

### 3.8. Notification unit 180

As a configuration for generating and generating an abnormality signal alarm when it is determined by the abnormality determination unit 150 that an abnormality occurs in the actual battery, specifically, when an abnormality signal is outputted from the abnormality signal generation unit 156, the notification unit recognizes that an abnormality occurs in the actual battery and generates an abnormality signal alarm, so that users can detect the abnormal state.

On the other hand, although the technical idea of the present invention has been specifically described according to the above embodiment, it should be noted that the above embodiments are for the purpose of explanation and not limitation.

## Claims

1. A battery SOH prediction method comprising:
a lookup table storage operation (S100) of constructing and storing a dQ/dV:SOH lookup table for a predetermined reference battery, for a completely charging-completely discharging cycle;
an SOH measurement battery voltage setting operation (S200) of measuring cycle specific dQ/dV values of a plurality of completely charging-completely discharging cycles and setting an SOH measurement battery voltage based on the measured cycle specific dQ/dV values, for the reference battery;
an actual dQ/dV value measurement operation (S300) of measuring an actual dQ/dV value at the set SOH measurement battery voltage at predetermined periodic intervals while charging the actual battery to predict an SOH;
a battery SOH prediction operation (S400) of extracting an SOH value corresponding to the measured actual dQ/dV value from the dQ/dV:SOH lookup table and predicting a real-time SOH of the actual battery;
**characterized in that** the method further comprises:
an abnormality determination operation (S600) of determining whether a battery is abnormal, wherein the abnormality determination operation (S600) comprises:
a dQ/dV value deviation calculation operation (S610) of calculating a deviation |dQ/dV(t)-dQ/dV(t-1)| between a dQ/dV value of a current period and a dQ/dV value of a previous period measured in the actual dQ/dV value measurement operation; and
a dQ/dV value deviation comparison operation (S620) of comparing the calculated dQ/dV value deviation between the current period and the previous period with a predetermined reference value; and
an abnormality notification operation (S700) of generating an abnormality signal alarm when it is determined that there is an abnormality in the actual battery in the abnormality determination operation.

2. The method of claim 1, wherein the SOH measurement battery voltage setting operation (S200) comprises:
a cycle specific dQ/dV value measurement operation of measuring the plurality of completely charging-completely discharging cycle specific dQ/dV values by performing an operation cycle of completely charging-completely discharging the reference battery a predetermined number of times;
a cycle specific dQ/dV value comparison operation of comparing the measured cycle specific dQ/dV values; and
a reference battery voltage derivation operation of deriving a battery voltage in which the dQ/dV value deviation is the largest among a plurality of cycles, as a result of the comparison.

3. The method of claim 2, wherein the battery SOH prediction operation (S400) comprises an SOH extraction operation of extracting an SOH corresponding to actual dQ/dV measured in the actual dQ/dV value measurement operation from the dQ/dV:SOH lookup table and is an operation of predicting the extracted SOH as a real-time SOH of the actual battery.

4. The method of claim 1, wherein when the dQ/dV value deviation between the current period and the previous period exceeds the predetermined reference value, it is determined that there is an abnormality in the corresponding battery.

5. A battery management device (100) for measuring an SOH of a battery (110), the device comprising:
a charge/discharge control unit (120) configured to supply charge/discharge power to the battery (110) and control charge/discharge;
an SOH measurement battery voltage setting unit (130) configured to set an SOH measurement battery voltage based on each cycle specific dQ/dV value measured for each cycle of a plurality of completely charging-completely discharging cycles for a predetermined reference battery;
an SOH prediction unit (140) configured to measure an actual dQ/dV value at the set SOH measurement battery voltage at predetermined periodic intervals while charging of the actual battery is in progress, and using this, predict a real-time SOH of the actual battery;
a storage unit (160) configured to store a lookup table, dQ/dV:SOH lookup table, that is a relationship between dQ/dV values at each battery voltage and a corresponding SOH, which is configured based on dQ/dV values measured during completely discharging and an SOH value corresponding thereto, for the reference battery;
an abnormality determination unit (150) configured to determine whether a corresponding battery has an abnormality, wherein the abnormality determination unit (150) comprises:
a dQ/dV deviation calculation unit (152) configured to calculate a deviation |dQ/dV(t)- dQ/dV(t-1)| between a dQ/dV value of a current period and a dQ/dV value of a previous period measured for the actual battery by the SOH prediction unit (140);
a comparison unit (154) configured to compare a dQ/dV value deviation between a current period and a previous period calculated by the dQ/dV deviation calculation unit (152) with a predetermined reference value;
**characterised in that** it further comprises:
an abnormality signal generation unit (156) configured to determine that there is an abnormality in the corresponding battery and generate and output an abnormality signal when the dQ/dV value deviation between the current period and the previous period exceeds a predetermined reference value upon a comparison result of the comparison unit (154); and
a notification unit (180) configured to generate an abnormality signal alarm when the abnormality determination unit determines that an abnormality occurs in the battery.

6. The device (100) of claim 5, further comprising:
a display unit (170) configured to display a real-time SOH of the actual battery predicted by the SOH prediction unit (140).

7. The device of claim 6, wherein the SOH measurement battery voltage setting unit (130) comprises:
a first dQ/dV value measurement unit (132) configured to measure cycle specific dQ/dV values of the plurality of completely charging-completely discharging cycles while the operation cycle of completely charging-completely discharging the reference battery by the charge/discharge control unit is performed a predetermined number of times; and
a reference battery voltage derivation unit (134) configured to compare each cycle specific dQ/dV value measured by the first dQ/dV value measurement unit (132), and derive a battery voltage in which the dQ/dV value deviation is the largest between a plurality of cycles,
wherein the SOH measurement battery voltage setting unit (130) sets the derived battery voltage as an SOH measurement battery voltage.

8. The device (100) of claim 7, wherein the SOH prediction unit (140) comprises:
a second dQ/dV value measurement unit (142) configured to measure the actual dQ/dV value at the set SOH measurement battery voltage at predetermined periodic intervals while charging the actual battery by the charge/discharge control unit; and
an SOH extraction unit (144) configured to extract an SOH corresponding to the actual dQ/dV value measured in the second dQ/dV value measurement unit from the dQ/dV:SOH lookup table stored in the storage unit (160),
wherein the SOH prediction unit (140) predicts the extracted SOH as a real-time SOH of the actual battery.

9. A battery pack comprising the battery management device (100) according to any one of claims 5 to 8.

## Patentansprüche

1. Batterie-SOH-Vorhersageverfahren, umfassend:
einen Nachschlagetabelle-Speichervorgang (S100) eines Erstellens und Speicherns einer dQ/dV:SOH-Nachschlagetabelle für eine vorbestimmte Referenzbatterie für einen Zyklus eines vollständigen-Ladens-vollständigen-Entladens;
einen SOH-Messung-Batteriespannung-Einstellungsvorgang (S200) eines Messens zyklusspezifischer dQ/dV-Werte einer Mehrzahl von Zyklen eines vollständigen-Ladens-vollständigen-Entladens
und eines Einstellens einer SOH-Messung-Batteriespannung auf Grundlage der gemessenen zyklusspezifischen dQ/dV-Werte für die Referenzbatterie;
einen konkreten dQ/dV-Wert-Messungsvorgang (S300) eines Messens eines konkreten dQ/dV-Wertes bei der eingestellten SOH-Messung-Batteriespannung an vorbestimmten periodischen Intervallen, während eines Ladens der konkreten Batterie, um einen SOH vorherzusagen;
einen Batterie-SOH-Vorhersagevorgang (S400) eines Extrahierens eines SOH-Wertes, welcher dem gemessenen konkreten dQ/dV-Wert aus der dQ/dV:SOH-Nachschlagetabelle entspricht, und eines Vorhersagens eines Echtzeit-SOH für die konkrete Batterie;
**dadurch gekennzeichnet, dass** das Verfahren ferner umfasst:
einen Auffälligkeit-Bestimmungsvorgang (S600) eines Bestimmens, ob eine Batterie auffällig ist, wobei der Auffälligkeit-Bestimmungsvorgang (S600) umfasst:
einen dQ/dV-Wert-Abweichung-Berechnungsvorgang (S610) eines Berechnens einer Abweichung | dQ/dV(t)-dQ/dV(t-1) | zwischen einem dQ/dV-Wert einer gegenwärtigen Periode und einem dQ/dV-Wert einer vorhergehenden Periode, welche in dem konkreten dQ/dV-Wert-Messungsvorgang gemessen werden; und
einen dQ/dV-Wert-Abweichung-Vergleichsvorgang (S620) eines Vergleichens der berechneten dQ/dV-Wert-Abweichung zwischen der gegenwärtigen Periode und der vorhergehenden Periode mit einem vorbestimmten Referenzwert; und
einen Auffälligkeit-Benachrichtigungsvorgang (S700) eines Erzeugens eines Auffälligkeitssignal-Alarms, wenn in dem Auffälligkeit-Bestimmungsvorgang bestimmt wird, dass eine Auffälligkeit in der konkreten Batterie vorhanden ist.

2. Verfahren nach Anspruch 1, wobei der SOH-Messung-Batteriespannung-Einstellungsvorgang (S200) umfasst:
einen zyklusspezifischen dQ/dV-Wert-Messungsvorgang eines Messens der Mehrzahl vollständig-Laden-vollständig-Entladenzyklusspezifischer dQ/dV-Werte durch Durchführen eines Vorgangszyklus eines vollständigen-Ladens-vollständigen-Entladens der Referenzbatterie vor eine vorbestimmte Anzahl von Malen;
einen zyklusspezifischen dQ/dV-Wert-Vergleichsvorgang eines Vergleichens der gemessenen zyklusspezifischen dQ/dV-Werte; und
einen Referenzbatteriespannung-Ableitungsvorgang eines Ableitens einer Batteriespannung, bei welcher die dQ/dV-Wert-Abweichung als ein Ergebnis des Vergleichs unter der Mehrzahl von Zyklen am größten ist.

3. Verfahren nach Anspruch 2, wobei der Batterie-SOH-Vorhersagevorgang (S400) einen SOH-Extrahiervorgang eines Extrahierens eines SOH, welcher konkretem dQ/dV entspricht, welches in dem konkreten dQ/dV-Wert-Messungsvorgang gemessen wird, aus der dQ/dV:SOH-Nachschlagetabelle umfasst und ein Vorgang eines Vorhersagens des extrahierten SOH als ein Echtzeit-SOH der konkreten Batterie ist.

4. Verfahren nach Anspruch 1, wobei, wenn die dQ/dV-Wert-Abweichung zwischen der gegenwärtigen Periode und der vorhergehenden Periode den vorbestimmten Referenzwert übersteigt, es bestimmt wird, dass eine Auffälligkeit in der entsprechenden Batterie vorhanden ist.

5. Batterieverwaltungsvorrichtung (100) zum Messen eines SOH einer Batterie (110), wobei die Vorrichtung umfasst:
eine Lade-/Entlade-Steuerungseinheit (120), welche dazu eingerichtet ist, der Batterie (110) einen Lade-/Entlade-Strom zuzuführen und ein Laden/Entladen zu steuern;
eine SOH-Messung-Batteriespannung-Einstellungseinheit (130), welche dazu eingerichtet ist, eine SOH-Messung-Batteriespannung auf Grundlage jedes zyklusspezifischen dQ/dV-Wertes einzustellen, welcher für jeden Zyklus aus einer Mehrzahl von Zyklen eines vollständigen-Ladens-vollständigen-Entladens für eine vorbestimmte Referenzbatterie gemessen worden ist;
eine SOH-Vorhersageeinheit (140), welche dazu eingerichtet ist, einen konkreten dQ/dV-Wert bei der eingestellten SOH-Messung-Batteriespannung an vorbestimmten periodischen Zeitintervallen zu messen, während ein Laden der konkreten Batterie durchgeführt wird, und, unter Verwendung davon, einen Echtzeit-SOH der konkreten Batterie vorherzusagen;
eine Speichereinheit (160), welche dazu eingerichtet ist, eine Nachschlagetabelle, dQ/dV:SOH-Nachschlagetabelle, d.h. ein Verhältnis zwischen dQ/dV-Werten bei jeder Batteriespannung und einem entsprechenden SOH, welcher auf Grundlage von dQ/dV-Werten eingerichtet ist, welche einem vollständigen Entladen gemessen worden sind, und einen SOH-Wert, welcher diesem entspricht, für die Referenzbatterie zu speichern;
eine Auffälligkeit-Bestimmungseinheit (150), welche dazu eingerichtet ist, zu bestimmen, ob eine entsprechende Batterie eine Auffälligkeit aufweist, wobei die Auffälligkeit-Bestimmungseinheit (150) umfasst:
eine dQ/dV-Abweichung-Berechnungseinheit (152), welche dazu eingerichtet ist, eine Abweichung | dQ/dV(t)-dQ/dV(t-1) | zwischen einem dQ/dV-Wert einer gegenwärtigen Periode und einem dQ/dV-Wert einer vorhergehenden Periode zu berechnen, welche durch die SOH-Vorhersageeinheit (140) für die konkrete Batterie gemessen worden sind;
eine Vergleichseinheit (154), welche dazu eingerichtet ist, eine dQ/dV-Wert-Abweichung zwischen einer gegenwärtigen Periode und einer vorhergehenden Periode zu vergleichen, welche mit einem vorbestimmten Referenzwert durch die dQ/dV-Abweichung-Berechnungseinheit (152) berechnet worden ist;
**dadurch gekennzeichnet, dass** sie ferner umfasst:
eine Auffälligkeitssignal-Erzeugungseinheit (156), welche dazu eingerichtet ist, zu bestimmen, dass eine Auffälligkeit in der entsprechenden Batterie vorhanden ist, und ein Auffälligkeitssignal zu erzeugen und auszugeben, wenn die dQ/dV-Wert-Abweichung zwischen der gegenwärtigen Periode und der vorhergehenden Periode im Hinblick auf ein Vergleichsergebnis der Vergleichseinheit (154) einen vorbestimmten Referenzwert übersteigt; und
eine Benachrichtigungseinheit (180), welche dazu eingerichtet ist, einen Auffälligkeitssignal-Alarm zu erzeugen, wenn die Auffälligkeit-Bestimmungseinheit bestimmt, dass in der Batterie eine Auffälligkeit auftritt.

6. Vorrichtung (100) nach Anspruch 5, ferner umfassend:
eine Anzeigeeinheit (170), welche dazu eingerichtet ist, einen Echtzeit-SOH der konkreten Batterie anzuzeigen, welcher durch die SOH-Vorhersageeinheit (140) vorhergesagt worden ist.

7. Vorrichtung nach Anspruch 6, wobei die SOH-Messung-Batteriespannung-Einstellungseinheit (130) umfasst:
eine erste dQ/dV-Wert-Messungseinheit (132), welche dazu eingerichtet ist, zyklusspezifische dQ/dV-Werte der Mehrzahl von Zyklen eines vollständigen-Ladens-vollständigen-Entladens zu messen, während der Vorgangszyklus eines vollständigen-Ladens-vollständigen-Entladens der Referenzbatterie durch die Lade-/Entlade-Steuerungseinheit für eine vorbestimmte Anzahl von Malen durchgeführt wird; und
eine Referenzbatteriespannung-Ableitungseinheit (134), welche dazu eingerichtet ist, jeden zyklusspezifischen dQ/dV-Wert zu vergleichen, welcher durch die erste dQ/dV-Wert-Messungseinheit (132) gemessen worden ist, und eine Batteriespannung abzuleiten, bei welcher die dQ/dV-Wert-Abweichung zwischen einer Mehrzahl von Zyklen am größten ist,
wobei die SOH-Messung-Batteriespannung-Einstellungseinheit (130) die abgeleitete Batteriespannung als eine SOH-Messung-Batteriespannung einstellt.

8. Vorrichtung (100) nach Anspruch 7, wobei die SOH-Vorhersageeinheit (140) umfasst:
Eine zweite dQ/dV-Wert-Messungseinheit (142), welche dazu eingerichtet ist, den konkreten dQ/dV-Wert bei der eingestellten SOH-Messung-Batteriespannung an vorbestimmten periodischen Intervallen zu messen, während eines Ladens der konkreten Batterie durch die Lade-/Entlade-Steuerungseinheit; und
eine SOH-Extrahiereinheit (144), welche dazu eingerichtet ist, einen SOH zu extrahieren, welcher dem konkreten dQ/dV-Wert entspricht, welcher in der zweiten dQ/dV-Wert-Messungseinheit aus der dQ/dV:SOH-Nachschlagetabelle gemessen worden ist, welche in der Speichereinheit (160) gespeichert ist,
wobei die SOH-Vorhersageeinheit (140) den extrahierten SOH als einen Echtzeit-SOH der konkreten Batterie vorhersagt.

9. Batteriepack, umfassend die Batterieverwaltungsvorrichtung (100) nach einem der Ansprüche 5 bis 8.

## Revendications

1. Procédé de prédiction de SOH de batterie comprenant :
une opération de stockage dans une table de consultation (S100) pour construire et stocker une table de consultation dQ/dV : SOH pour une batterie de référence prédéterminée, pendant un cycle de charge complète-décharge complète ;
une opération de réglage de tension de batterie de mesure de SOH (S200) pour mesurer des valeurs dQ/dV spécifiques d'un cycle d'une pluralité de cycles de charge complète-décharge complète et régler une tension de batterie de mesure de SOH sur la base des valeurs dQ/dV spécifiques d'un cycle mesurées, pour la batterie de référence ;
une opération de mesure de valeur dQ/dV effective (S300) pour mesurer une valeur dQ/dV effective à la tension de batterie de mesure de SOH réglée à intervalles périodiques prédéterminés tout en chargeant la batterie effective pour prédire un SOH ;
une opération de prédiction de SOH de batterie (S400) pour extraire une valeur de SOH correspondant à la valeur dQ/dV effective mesurée à partir de la table de consultation dQ/dV : SOH et prédire un SOH en temps réel de la batterie effective ;
**caractérisé en ce que** le procédé comprend en outre :
une opération de détermination d'anomalie (S600) pour déterminer si une batterie est anormale, dans lequel l'opération de détermination d'anomalie (S600) comprend :
une opération de calcul d'écart de valeurs dQ/dV (S610) pour calculer un écart |dQ/dV(t)-dQ/dV(t-1)| entre une valeur dQ/dV d'une période courante et une valeur dQ/dV d'une période précédente mesurée lors de l'opération de mesure de valeurs dQ/dV effectives ; et
une opération de comparaison d'écart de valeurs dQ/dV (S620) pour comparer l'écart de valeurs dQ/dV calculé entre la période courante et la période précédente avec une valeur de référence prédéterminée ; et
une opération de notification d'anomalie (S700) pour générer une alarme de signal d'anomalie lorsqu'il est déterminé qu'il existe une anomalie dans la batterie effective lors de l'opération de détermination d'anomalie.

2. Procédé selon la revendication 1, dans lequel l'opération de réglage de tension de batterie de mesure de SOH (S200) comprend :
une opération de mesure de valeurs dQ/dV spécifiques d'un cycle pour mesurer la pluralité de valeurs dQ/dV spécifiques d'un cycle de charge complète-décharge complète en réalisant un cycle de fonctionnement de charge complète-décharge complète de la batterie de référence un nombre de fois prédéterminé ;
une opération de comparaison de valeurs dQ/dV spécifiques d'un cycle pour comparer les valeurs dQ/dV spécifiques d'un cycle mesurées ; et
une opération de déduction de tension de batterie de référence pour déduire une tension de batterie dans laquelle l'écart de valeurs dQ/dV est le plus important parmi une pluralité de cycles, suite à la comparaison.

3. Procédé selon la revendication 2, dans lequel l'opération de prédiction de SOH de batterie (S400) comprenant une opération d'extraction de SOH pour extraire un SOH correspondant au dQ/dV effectif mesuré lors de l'opération de mesure de valeurs dQ/dV effectives à partir de la table de consultation dQ/dV : SOH et est une opération de prédiction du SOH extrait en tant que SOH en temps réel de la batterie effective.

4. Procédé selon la revendication 1, dans lequel lorsque l'écart de valeurs dQ/dV entre la période courante et la période précédente dépasse la valeur de référence prédéterminée, il est déterminé qu'il existe une anomalie dans la batterie correspondante.

5. Dispositif de gestion (100) de batterie pour mesurer un SOH d'une batterie (110), le dispositif comprenant :
une unité de commande de charge/décharge (120) configurée pour alimenter en énergie de charge/décharge la batterie (110) et commander la charge/décharge ;
une unité de réglage de tension de batterie de mesure de SOH (130) configurée pour régler une tension de batterie de mesure de SOH sur la base de chaque valeur dQ/dV spécifique d'un cycle mesurée pour chaque cycle d'une pluralité de cycles de charge complète-décharge complète pour une batterie de référence prédéterminée ;
une unité de prédiction de SOH (140) configurée pour mesurer une valeur dQ/dV effective à la tension de batterie de mesure de SOH réglée à intervalles périodiques prédéterminés pendant que la charge de la batterie effective est en cours, et à l'aide de celle-ci, prédire un SOH en temps réel de la batterie effective ;
une unité de stockage (160) configurée pour stocker une table de consultation, table de consultation dQ/dV : SOH, qui est une relation entre des valeurs dQ/dV à chaque tension de batterie et un SOH correspondant, qui est configurée sur la base de valeurs dQ/dV mesurées pendant une décharge complète et une valeur de SOH correspondant à celle-ci, pour la batterie de référence ;
une unité de détermination d'anomalie (150) configurée pour déterminer si une batterie correspondante présente une anomalie, dans lequel l'unité de détermination d'anomalie (150) comprend :
une unité de calcul d'écart dQ/dV (152) configurée pour calculer un écart |dQ/dV(t)-dQ/dV(t-1)| entre une valeur dQ/dV d'une période courante et une valeur dQ/dV d'une période précédente mesurée pour la batterie effective par l'unité de prédiction de SOH (140) ;
une unité de comparaison (154) configurée pour comparer un écart de valeurs dQ/dV entre une période courante et une période précédente calculé par l'unité de calcul d'écart dQ/dV (152) avec une valeur de référence prédéterminée ;
**caractérisé en ce qu'**il comprend en outre :
une unité de génération de signal d'anomalie (156) configurée pour déterminer qu'il existe une anomalie dans la batterie correspondante et générer et émettre un signal d'anomalie lorsque l'écart de valeurs dQ/dV entre la période courante et la période précédente dépasse une valeur de référence prédéterminée en fonction d'un résultat de comparaison de l'unité de comparaison (154) ; et
une unité de notification (180) configurée pour générer une alarme de signal d'anomalie lorsque l'unité de détermination d'anomalie détermine qu'une anomalie a lieu dans la batterie.

6. Dispositif (100) selon la revendication 5, comprenant en outre :
une unité d'affichage (170) configurée pour afficher un SOH en temps réel de la batterie effective, prédit par l'unité de prédiction de SOH (140).

7. Dispositif selon la revendication 6, dans lequel l'unité de réglage de tension de batterie de mesure de SOH (130) comprend :
une première unité de mesure de valeurs dQ/dV (132) configurée pour mesurer des valeurs dQ/dV spécifiques d'un cycle de la pluralité de cycles de charge complète-décharge complète en même temps que le cycle de fonctionnement de charge complète-décharge complète de la batterie de référence par l'unité de commande de charge/décharge est réalisé un nombre de fois prédéterminé ; et
une unité de déduction de tension de batterie de référence (134) configurée pour comparer chaque valeur dQ/dV spécifique d'un cycle mesurée par la première unité de mesure de valeurs dQ/dV (132), et déduire une tension de batterie dans laquelle l'écart de valeurs dQ/dV est le plus important entre une pluralité de cycles,
dans lequel l'unité de réglage de tension de batterie de mesure de SOH (130) règle la tension de batterie déduite en tant que tension de batterie de mesure de SOH.

8. Dispositif (100) selon la revendication 7, dans lequel l'unité de prédiction de SOH (140) comprend :
une seconde unité de mesure de valeurs dQ/dV (142) configurée pour mesurer la valeur dQ/dV effective à la tension de batterie de mesure de SOH réglée à intervalles périodiques prédéterminés pendant la charge de la batterie effective par l'unité de commande de charge/décharge ; et
une unité d'extraction de SOH (144) configurée pour extraire un SOH correspondant à la valeur dQ/dV effective mesurée dans la seconde unité de mesure de valeurs dQ/dV à partir de la table de consultation dQ/dV : SOH stockée dans l'unité de stockage (160), dans lequel l'unité de prédiction de SOH (140) prédit le SOH extrait en tant que SOH en temps réel de la batterie effective.

9. Bloc-batterie comprenant le dispositif de gestion (100) de batterie selon l'une quelconque des revendications 5 à 8.
